# EUROPEAN PATENT SPECIFICATION

(11) **EP 3 910 921 B1**
(45) Date of publication and mention of the grant of the patent: **20.09.2023**
(21) Application number: 20774534.0
(22) Date of filing: 09.03.2020
(51) Int. Cl.: H04M 1/02, G06F 1/16, H04N 23/57

(54) **ELECTRONIC DEVICE, DISPLAY SCREEN ASSEMBLY AND COVER PLATE**
ELEKTRONISCHE VORRICHTUNG, ANZEIGESCHIRM UND ABDECKPLATTE
DISPOSITIF ÉLECTRONIQUE, ENSEMBLE ÉCRAN D'AFFICHAGE ET PLAQUE DE RECOUVREMENT

(30) Priority: 19.03.2019 CN 201920352149 U
(43) Date of publication of application: 17.11.2021
(73) Proprietor: GUANGDONG OPPO MOBILE TELECOMMUNICATIONS CORP., LTD., Dongguan, Guangdong 523860 (CN)
(72) Inventor: WEN, Quanhao, Dongguan, Guangdong 523860 (CN)
(74) Representative: Thorniley, Peter
(86) International application number: PCT/CN2020/078412
(87) International publication number: WO 2020/187076

(56) References cited:
- CN-U- 207 926 663

## Description

### 1. Field of the Disclosure

The present application relates to a technical field of electronic devices, and more particularly to an electronic device with a camera module having a portion disposed at a border of a middle frame.

### 2. Description of the Related Art

A front camera is typically disposed at the top of an electronic device. It needs a groove for reserving an area for light entrance into the front camera. The groove is typically provided on a middle plate surrounded by a border. The middle plate and the border are integrated to form a middle frame. When the size of the groove is large, it will affect the beauty of the electronic device.

CN207926663U and CN207354360U are relevant background arts in this field.

### SUMMARY

The present invention is defined in the appended claims. Any embodiment in the description that does not fall within the scope of the claims shall be regarded as an example for understanding the present invention.

Based on this, it needs to provide an electronic device.

An electronic device includes:
a display screen, having a flat area;
a middle frame, including a border surrounding the display screen, wherein the border is provided with a groove, and the border is provided with a through hole that penetrates a bottom of the groove;
a camera module, all or part of which is located inside the border, wherein the camera module includes a lens for light entrance, and the lens exposes by means of the through hole; and
a cover plate, including a convex plate and a base plate that are integrated into one piece, wherein the convex plate is protruded from an edge at a side of the base plate, and when the base plate and the convex plate are orthographically projected onto a first reference plane, contours of orthographic projection of the base plate and contours of orthographic projection of the convex plate intersect at two points, the two points are connected to each other to form a reference straight line, the base plate is located at a side of the reference straight line, and the convex plate is located at the other side of the reference straight line; the base plate covers the display screen, and the convex plate is accommodated in the groove and covers the lens; the convex plate includes a left face and a right face disposed opposite to each other, and a first external surface disposed away from the lens and connected between the left face and the right face, the convex plate comprises a top face at a side opposite to the base plate, the top face is connected between the left face and the right face,
wherein a boundary of an angle of coverage of the camera module intersects with the first external surface to form intersections, wherein a minimal distance between the intersections and the top face is 0.2mm to 1.4mm; or a minimal distance between the intersections and the left face or the right face is 0.2mm to 1.4mm.

### BRIEF DESCRIPTION OF THE DRAWINGS

For explaining the technical solutions used in the existing arts or the embodiments of the present application more clearly, the appending figures to be used in describing the existing arts or the embodiments will be briefly introduced below. Obviously, the appending figures described below are only some of the embodiments of the present application, and those of ordinary skill in the art can further obtain other figures according to these figures without making any inventive effort.
FIG. 1 is a stereoscopic diagram of an electronic device provided in an embodiment.
FIG. 2 is an enlarged diagram of Part C of the electronic device shown in FIG. 1.
FIG. 3 is a primary view of the electronic device shown in FIG. 1.
FIG. 4 is a top view of the electronic device shown in FIG. 3.
FIG. 5 is an exploded view of the electronic device shown in FIG. 1.
FIG. 6 is an enlarged diagram of Part D of the electronic device shown in FIG. 5.
FIG. 7 is an enlarged diagram of Part E of the electronic device shown in FIG. 5.
FIG. 8 is a stereoscopic diagram of a camera module of the electronic device shown in FIG. 5.
FIG. 9 is a cross-sectional view of the electronic device shown in FIG. 3 along B-B.
FIG. 10 is an enlarged diagram of Part F of the electronic device shown in FIG. 9 in an embodiment.
FIG. 11 is an enlarged diagram of Part F of the electronic device shown in FIG. 9 in another embodiment.
FIG. 12 is an enlarged diagram of Part G of the electronic device shown in FIG. 9.
FIG. 13 is an enlarged diagram of Part F of the electronic device shown in FIG. 9 in still another embodiment.
FIG. 14 is a top view of the electronic device shown in FIG. 3 in another embodiment.
FIG. 15 is a structural schematic diagram illustrating an electronic device provided in an embodiment of the present application.

### DETAILED DESCRIPTION OF THE EMBODIMENTS

For ease of understanding the present application, the present application will be described below more comprehensively with reference to related figures. Preferred embodiments of the present application are shown in the figures. However, the present application may be implemented in many different forms and is not limited to the embodiments described herein. Instead, these embodiments are provided to make the contents disclosed in the present application more thoroughly and comprehensively.

"Terminal device" used here includes, but is not limited to, a device connected in any one or a few of the following connection manners and capable of receiving and/or transmitting communication signals:
(1) a wired connection manner, for example, a Public Switched Telephone Network (PSTN), a Digital Subscriber Line (DSL), a digital cable and direct cable connection; and
(2) a wireless interface manner, for example, a cellular network, a Wireless Local Area Network (WLAN), a digital television network like a Digital Video Broadcasting Handheld (DVB-H) network, a satellite network and an Amplitude Modulation (AM)-Frequency Modulation (FM) broadcast transmitter.

A terminal device configured to communicate by a wireless interface may be called a "mobile terminal". Examples of the mobile terminal include, but are not limited to, the following electronic devices:
(1) a satellite phone or a cell phone;
(2) a Personal Communication System (PCS) terminal capable of integrating a cellular radio phone and data processing, faxing and data communication capabilities;
(3) a radio phone, a pager, Internet/intranet access, a Web browser, a memo pad, a calendar and a Personal Digital Assistant (PDA) equipped with a Global Positioning System (GPS) receiver;
(4) a conventional laptop and/or palmtop receiver, and
(5) a conventional laptop and/or palmtop radio phone transceiver and the like.

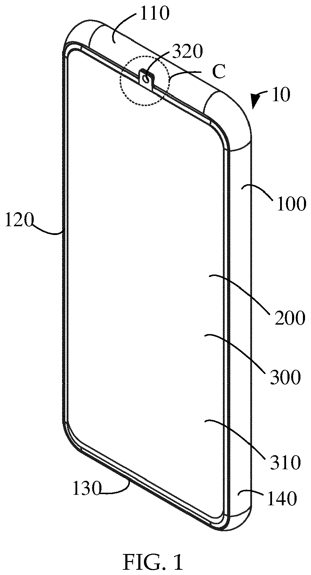

As shown in FIG. 1, FIG. 3 and FIG. 5, an electronic device 10 is provided in an embodiment. The electronic device 10 may be a smartphone, a computer or a tablet. The electronic device 10 includes a display screen assembly, a middle frame 100, a battery cover 600 and a mother board 700. The display screen assembly and the battery cover 600 are fixed at two sides of the middle frame 100, respectively. The display screen assembly, the middle frame 100 and the battery cover 600 form an external structure of the electronic device 10. The mother board 700 is located inside the electronic device 10. Electronic components such as a controller, a storage unit, a power management unit, a baseband chip and etc., are integrated on the mother board 700. The display screen assembly is used to display a screen or text font. The mother board 700 can control operations of the electronic device 10.

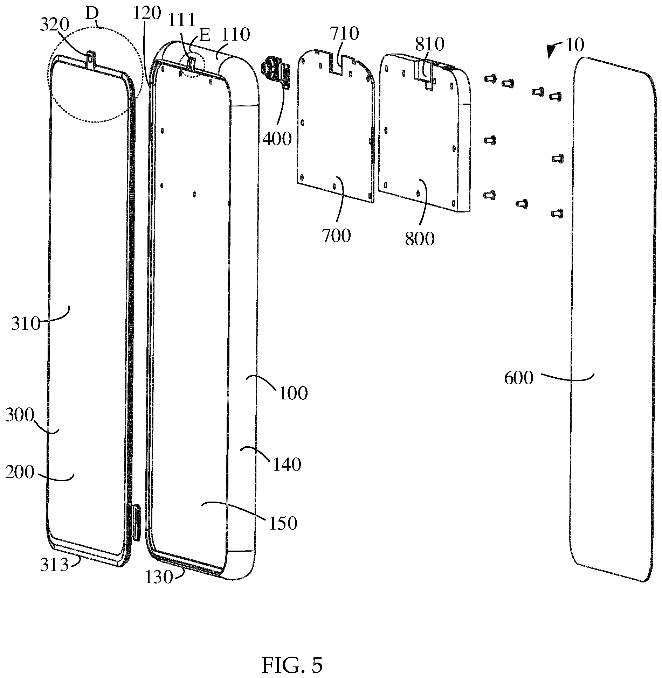

As shown in FIG. 5, in an embodiment, the middle frame 100 includes a border and a middle plate 150 that are integrated into one piece. The middle plate 150 is of a rectangular or square structure with four round corners. The border surrounds the periphery of the middle plate 150. Case structures with openings are formed at two sides of the border and the middle plate 150. The display screen assembly is fastened in the case structure at one side and the battery cover 600 is fastened in the case structure at the other side. The mother board 700 and a pressing plate 800 are disposed between the middle plate 150 and the battery cover 600. The mother board 700 and the pressing plate 800 are fastened to each other, by screws, at a side of the middle plate 150 facing the battery cover 600. It will be appreciated that when a user normally uses the electronic device 10 to make a phone call, a speaker of the electronic device 10 faces the ear, a microphone of the electronic device 10 faces the mouth, and the electronic device 10 is approximately perpendicular to the ground. Then, an end facing the top is a top end of the electronic device 10, an end facing the bottom is a bottom end of the electronic device 10, an end facing the left is a left end of the electronic device 10, and an end facing the right is a right end of the electronic device 10. The distance between the left end and the right end is defined as a width of the electronic device 10, the distance between the top end and the bottom end is defined as a length of the electronic device 10, and the distance between an external surface of the display screen assembly and an external surface of the battery cover 600 is defined as a thickness of the electronic device 10.

As shown in FIG. 5, in an embodiment, the border surrounds the display screen assembly and includes a first lateral frame 120 and a second lateral frame 140 disposed opposite to each other and a bottom frame 130 disposed opposite to a top frame 110. The first lateral frame 120 is connected to one end of the top frame 110 and the bottom frame 130, and the second lateral frame 140 is connected to the other end of the top frame 110 and the bottom frame 130. The first lateral frame 120 is located at the left end of the electronic device 10, the second lateral frame 140 is located at the right end of the electronic device 10, the top frame 110 is located at the top end of the electronic device 10, and the bottom frame 130 is located at the bottom end of the electronic device 10.

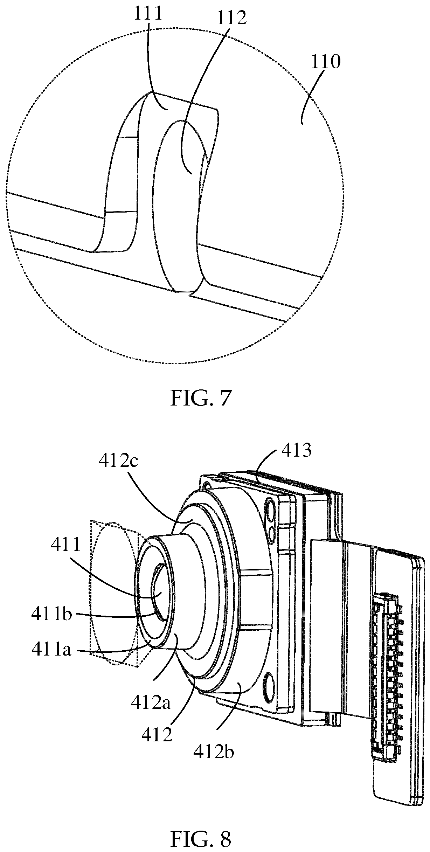

As shown in FIG. 5 and FIG. 8, in an embodiment, the electronic device 10 includes a camera module 400. The camera module 400 includes a lens barrel 412, a base 413, a flexible circuit board and etc. The flexible circuit board is connected to the base 413. Components such as an image processor, an autofocusing (AF) driver assembly, an infrared filter, a storage and etc, are provided inside the base 413 for realizing imaging an outer object. The lens barrel 412 is connected to the base 413, and an inner chamber of the lens barrel 412 communicates with an inner chamber of the base 413. A lens 411 used for light entrance and capable of propagating the light and other optical lenses configured to propagating the light are provided inside the lens barrel 412. An end of the lens barrel 412 located away from the base 413 is a distal wall 411a. The distal wall 411a is provided with a light receiving opening 411b. The lens 411 exposes by means of the light receiving opening 411b.

As shown in FIG. 8, in another embodiment, the lens barrel 412 includes a first protruding platform 412a and a second protruding platform 412b that are connected to each other. The second protruding platform 412b is connected between the first protruding platform 412a and the base 413. The second protruding platform 412b includes a stair face 412c surrounding the first protruding platform 412a. The distal wall 411a is located at a side of the first protruding platform 412a away from the base 413. The lens 411 mounts inside the first protruding platform 412a and exposes by means of the light receiving opening 411b provided on the distal wall 411a.

As shown in FIG. 7, FIG. 9 and FIG. 10, in an embodiment, an inner wall of the top frame 110 is dented toward the outside of the electronic device 10 to form a receiving space for mounting the camera module 400. At least part of the camera module 400 is installed in the receiving space. The top frame 110 is provided with a groove 111 at a side of the top frame 110 close to the cover plate 300. The groove 111 penetrates an external surface of the top frame 110, and the top frame 110 is provided with a through hole 112 penetrating a bottom of the groove 111. The through hole 112 communicates with the receiving space. The lens 411 exposes by means of the through hole 112 such that ambient light can irradiate at the lens 411 via the through hole 112. The lens 411 faces in a direction that is the same as the display screen 200 such that the electronic device 10 can take a picture or record a video from the front side. In an embodiment, as shown in FIG. 7, the through hole 112 penetrates an edge of the top frame 110. That is, the through hole 112 is at least partially located in the groove 111 so as to avoid weakening the structural strength of the top frame 111 too much and prevent the height of the top frame 110 from increasing too much. It will be appreciated that at least a part of the camera module 400 is located in the top frame 110, the lens 411 exposes by means of the through hole 112 perforated from the top frame 110, and these can increase a screen-to-body ratio of the electronic device 10 and realize a full screen display of the electronic device 10.

As shown in FIG. 5, in an embodiment, the mother board 700 is provided with a notch 710, and the camera module 400 is disposed penetrating the notch 710. This structure can prevent the camera module 400 from being disposed overlapping with the mother board 700. It is beneficial for decreasing overall thickness of the electronic device 10 and facilitating lightening and thinning of the electronic device 10. In another embodiment, the pressing plate 800 is located at a side of the mother board 700 facing the battery cover 600, and the pressing plate 800 and the mother board 700 are fastened to the middle plate 150 by screws. The pressing plate 800 is provided with a receiving slot 810, a part of the camera module 400 is received in the receiving slot 810, and the pressing plate 800 abuts on the camera module 400. In such a way, the camera module 400 is fixed. It will be appreciated that the pressing plate 800 is not necessary, and the camera module 400 can also be fixed or positioned using other approaches, which are not restricted herein.

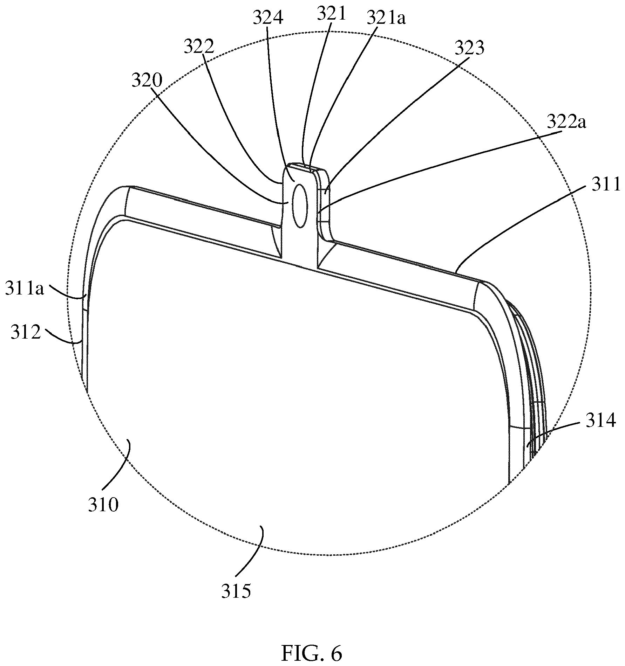

As shown in FIG. 5 and FIG. 6, in an embodiment, the display screen assembly includes a cover plate 300 and a display screen 200, and the cover plate 300 covers the display screen 200 at a side of the display screen 200 away from the middle plate 150. In an embodiment, the display screen 200 utilizes a liquid crystal display (LCD) screen for displaying information. The LCD screen can be a thin-film transistor (TFT) screen 230 or an in-plane switching (IPS) screen 230 or a splice liquid crystal display (SLCD) screen 230. In another embodiment, the display screen 200 utilizes an organic light-emitting diode (OLED) screen for displaying information. The OLED screen can be an active matrix organic light emitting diode (AMOLED) screen 230 or a super active matrix organic light emitting diode (super AMOLED) screen 230 or a super active matrix organic light emitting diode plus (super AMOLED plus) screen 230. It will be appreciated that it is preferred to adopt the OLED screen as the display screen 200. This type of screen is thin and it is beneficial for reducing the thickness of the electronic device 10. Under the control of a controller, the display screen 200 can display information and provide operation interfaces for users.

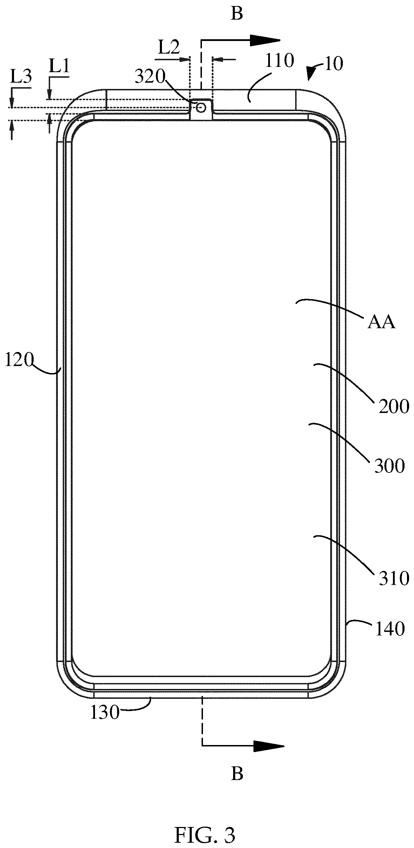

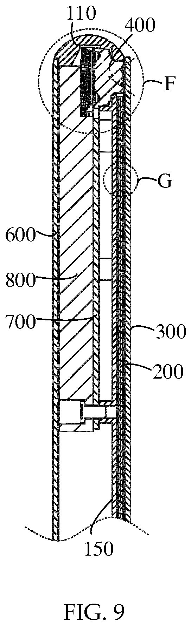

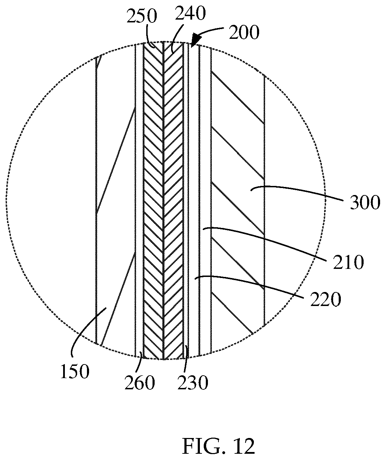

As shown in FIG. 9 and FIG. 12, in an embodiment, a display area of the display screen 200 is shaped as a rectangle or a rectangle with round corners. The display area is an active area (AA) shown in FIG. 3. The display screen 200 includes a first optical adhesive layer 210, a polarizer 220, a screen 230, a second optical adhesive layer 240, a foam layer 250 and a heat sink 260 that are arranged in order along a direction away from the cover plate 300. The first optical adhesive layer 210 is made of transparent optical clear adhesive (OCA) and is configured to adhere the cover plate 300 to the polarizer 220. The thickness of the first optical adhesive layer 210 is less than or equal to 0.15mm. The polarizer 220 is located between the first optical adhesive layer 210 and the screen 230. The thickness of the polarizer 220 is less than or equal to 0.147mm. The thickness of the screen 230 is less than or equal to 0.03mm. The screen 230 can display images. The second optical adhesive layer 240 is made of transparent optical clear adhesive (OCA) and is configured to adhere the screen 230 to the foam layer 250. The thickness of the second optical adhesive layer 240 is less than or equal to 0.088mm. The foam layer 250 is located at a side of the second optical adhesive layer 240 away from the screen 230 and has sealing and damping functions. The thickness of the foam layer 250 is less than or equal to 0.239mm. The heat sink 260 is disposed at a side of the foam layer 250 away from the second optical adhesive layer 240 for ease of heat dissipation of the screen 230. The thickness of the heat sink 260 is less than or equal to 0.03mm.

As shown in FIG. 5, in an embodiment, the cover plate 300 is made of transparent glass with light transmittance no less than 80%. The thickness of the cover plate 300 is less than or equal to 0.55mm. The cover plate 300 includes a convex plate 320 and a base plate 310 that are integrated into one piece. The convex plate 320 is protruded from an edge at a side of the base plate 310. The base plate 310 covers the display area of the display region 200. The convex plate 320 is located outside of the display area of the display screen 200. The convex plate 320 is received in the groove 111. It will be appreciated that "the convex plate 320 is protruded from an edge at a side of the base plate 310" can be interpreted by the following manner. A plane where the display screen 200 is located is defined as a first reference plane. If the base plate 310 and the convex plate 320 are orthographically projected onto the first reference plane, a curved line is formed at the periphery of orthographic projection of an edge of the base plate 310 located at a same side as the convex plate 320 onto the first reference plane. The curved line includes two line segments located at two sides of the convex plate 320, respectively. A reference straight line is formed by connecting the two line segments. Then, the base plate 310 is located at a side of the reference straight line, and the convex plate 320 is located at the other side of the reference straight line. Likewise, it can be appreciated that when the base plate 310 and the convex plate 320 are orthographically projected onto the first reference plane, contours of orthographic projection of the base plate 310 and contours of orthographic projection of the convex plate 320 intersect at two points. The two points are connected to each other to form a reference straight line. The base plate 310 is located at a side of the reference straight line, and the convex plate 320 is located at the other side of the reference straight line. It will be appreciated that the base plate 310 includes a flat area. A plane where the flat area of the base plate 310 is located is defined as a second reference plane. The second reference plane is parallel with the first reference plane.

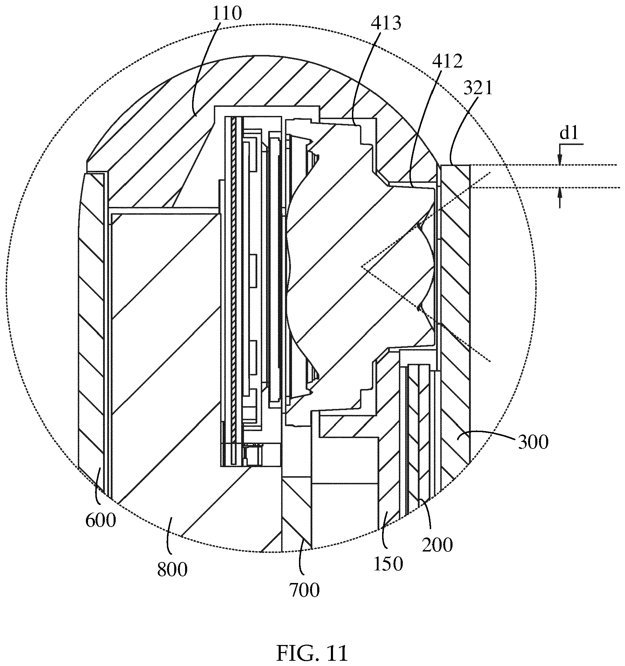

As shown in FIG. 3 and FIG. 11, in an embodiment, the convex plate 320 includes a top face 321 at a side opposite to the base plate 310, a left face 322 and a right face 323 disposed opposite to each other, and a first external surface 324 disposed away from the lens 411. The top face 321 is connected between the left face 322 and the right face 323. The top face 321, the left face 322 and the right face 323 all intersects with the first external surface 323 to form right angles. A boundary of an angle of coverage of the camera module 400 intersects with the first external surface 324 to form intersections. A minimal distance d1 between the intersections and the top face 321, between the intersections and the left face 322 or between the intersections and the right face 323 is 0.2mm to 1.4mm, preferably, 0.25mm. In the present embodiment, the distance between the left face 322 and the right face 323 is the width of the convex plate 320. The width L of the convex plate 320 is 2.8mm to 4.4mm, preferably, 3.2mm. The base plate 310 includes a top side face 311 at a side close to the top frame 110. The distance between the top face 321 and the top side face 311 is a height of the convex plate 320 protruded from the base plate 310. The height L1 of the convex plate 320 protruded from the base plate 310 is 3.6mm to 4.8mm, preferably, 3.65mm. It will be appreciated that for different widths of the intersections formed by different angles of coverage of the camera module 400 and the first external surface 324, the height of the convex plate 320 protruded from the base plate 310 and the width of the convex plate 320 may differ. In the embodiment, the minimal distance d1 between the intersections and the top face 321, between the intersections and left face 322 or between the intersections and the right face 323 is small. The edges of the convex plate 320 can be closer to an optical axis of the camera module 400. In this way, the height L1 of the convex plate 320 protruded from the base plate 310 and the width L2 of the convex plate 320 are smaller. Thus, the size of the groove 111 required to be provided on the top frame 110 is smaller. It is beneficial for improving the appearance of the electronic device 10.

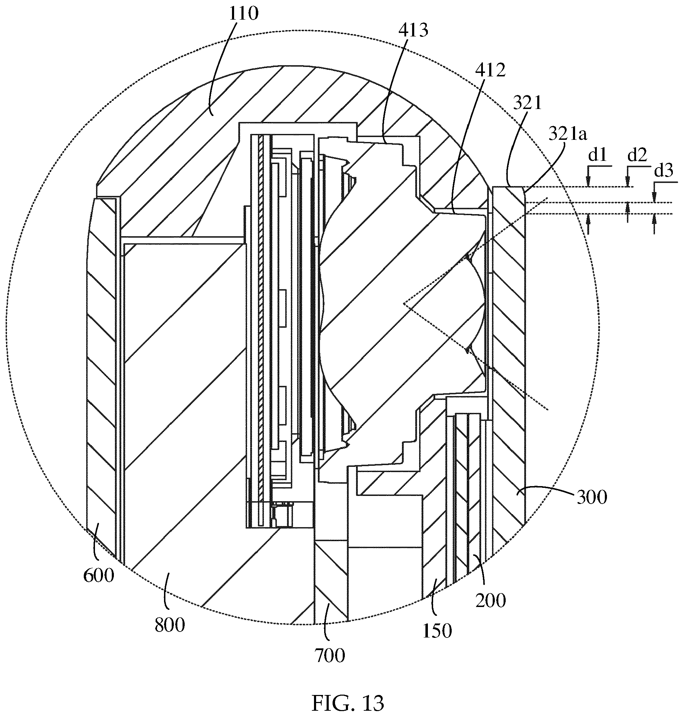

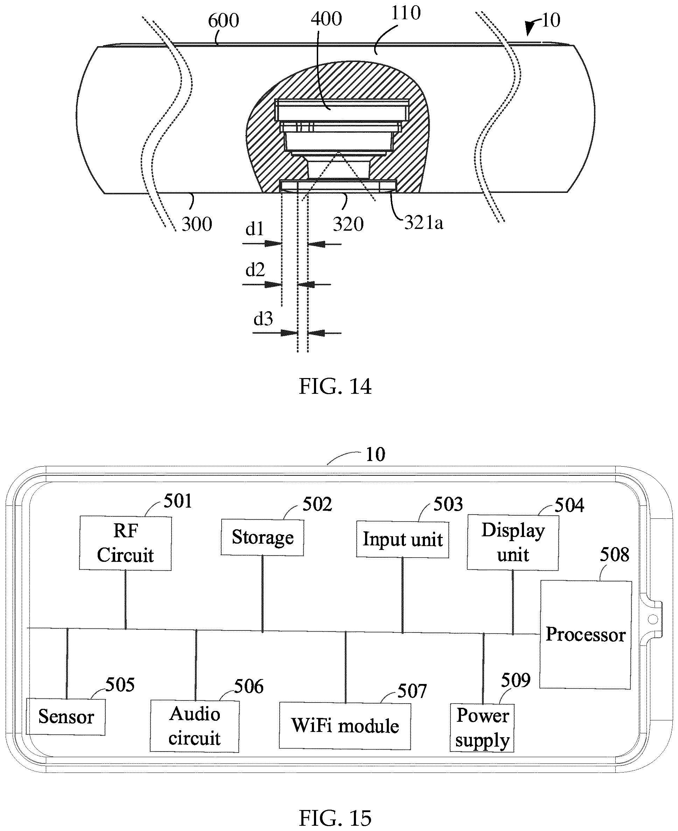

As shown in FIG. 13 and FIG. 14, if a first transition face 321a is formed by means of rounding an intersection between the top face 321 and the first external surface 324, a second transition face 322a is formed by means of 2.5D smooth transition of curvature between the first external surface 324 and the left face 322 or between the first external surface 324 and the right face 323, and both the first transition face 321a and the second transition face 322a are 2.5D curved faces, the first transition face 321a and the second transition face 322a have a same width, both of them are d2, and d2 is 0.8mm to 1.6mm, preferably, 1.6mm. It will be appreciated that the width of the first transition face 321a is a width of orthographic projection of the first transition face 321a onto the first reference plane; and the width of the second transition face 322a is a width of orthographic projection of the second transition face 322a onto the first reference plane. Moreover, curved face processing will damage the glass close to the curved face, and thus, it needs to reserve a distance between the intersections and the first transition face 321a or between the intersections and the second transition face 322a and serve the distance as a safe distance d3, where d3 is no less than 0.6mm. In forming 2.5D curved transition faces by means of rounding the intersections between the first external surface 324 and the top face 321, between the first external surface 324 and the left face 322 and between the first external surface 324 and the right face 323, the minimal distance d1 between the top face 321 and the intersections formed by means of intersecting the angle of coverage of the camera module 400 and the first external surface 324, between left face 322 and the intersections or between the right face 323 and the intersections is d2+d3. Minimal values of d1 range from 1.4mm to 2.2mm. This causes a large distance between the intersections and the top face 321, the left face 322, the right face 323 such that the height L1 of the convex plate 320 protruded from the base plate 310 is large in size and the width L2 of the convex plate 320 is large in size. The groove 111 provided on the top frame 110 needs to be large in size for receiving the convex plate 320.

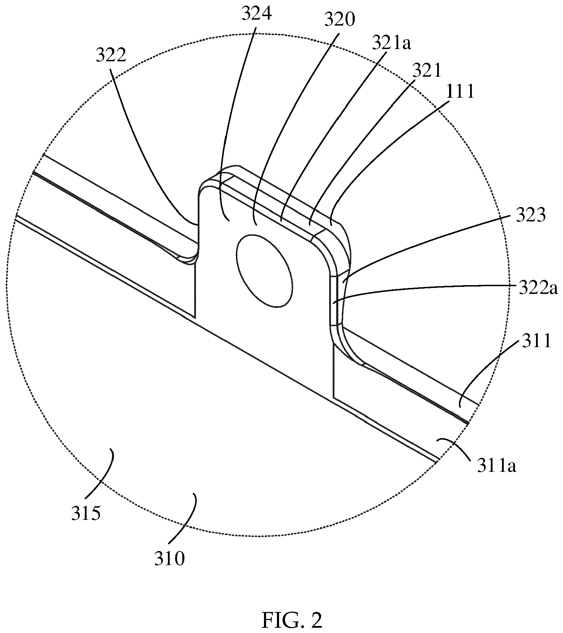

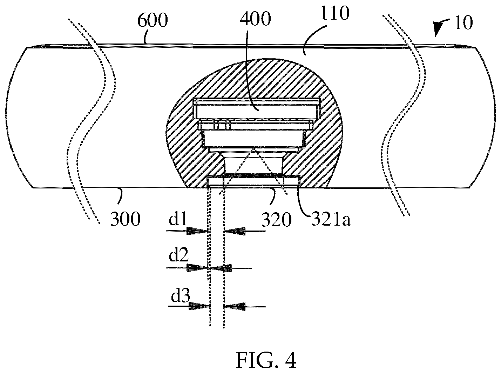

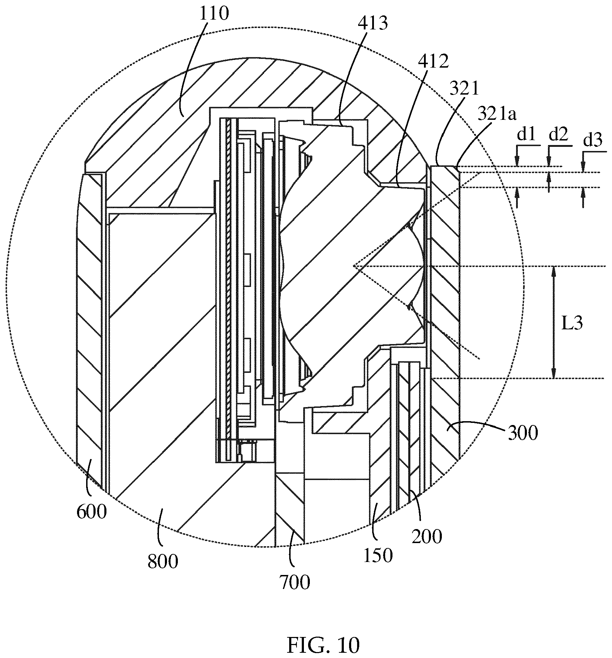

As shown in FIG. 2, FIG. 4 and FIG. 10, in an embodiment, an intersection between the top face 321 and the first external surface 324 are chamfered to form the first transition face 321a, which is a plane; intersections between the left face 322 and the first external surface 324 and between the right face 323 and the first external surface 324 are both chamfered to form the second transition face 322a, which is a plane. It will be appreciated that the first transition face 321a and the second transition face 322a can also be curved faces by means of rounding. The first transition face 321a and the second transition face 322a can increase the strength of the cover plate 300, avoiding stress accumulated at the edges of the convex plate 320. In the present embodiment, the first transition face 321a and the second transition face 322a have a same width d2, and both of them are 0.1mm to 0.8mm. The safe distance d3 is no less than 0.1mm and is no greater than 0.6mm. The minimal distance d1 between the top face 321 and the intersections formed by means of intersecting the angle of coverage of the camera module 400 and the first external surface 324, between left face 322 and the intersections and between the right face 323 or the intersections is d2+d3. Minimal values of d1 range from 0.2mm to 1.4mm. For example, the width d2 of the first transition face 321a and the second transition face 322a is 0.15mm, the safe distance d3 is 0.25mm, and then the minimal distance d3 between the intersections and the top face 321, the left face 322, the right face 323 is 0.4mm. In the present embodiment, an inclined plane formed by chamfering the intersection between the top face 321 and the first external surface 324 serves as the first transition face 321a, and inclined planes formed by chamfering the intersections between the left face 322 and the first external surface 324 and between the right face 323 and the first external surface 324 serve as the second transition faces 322a. Compared to 2.5D curved faces, this configuration makes the edges of the convex plate 320 be closer to the optical axis of the camera module 400. The height of the convex plate 320 protruded from the base plate 310 and the width of the convex plate 320 are reduced as well as the strength of the cover plate 300 is enhanced. As shown in FIG. 3 and FIG. 10, in an embodiment, the camera module 400 includes the optical axis. A distance L3 between the optical axis and the display area of the display screen 200 is 3.4mm. It will be appreciated that the values of L3 will be changed when the electronic device 10 uses different sizes of camera module 400.

As shown in FIG. 5 and FIG. 6, in an embodiment, the base plate 310 includes a left side face 312, a right side face 314, a bottom side face 313 disposed opposite to the top side face 311, and a second external surface 315 disposed opposite to the display screen 200. The second external surface 315 and the first external surface 324 are coplanar. The left side face 312 is connected to one end of the top side face 311 and the bottom side face 313, and the right side face 314 is connected to the other end of the top side face 311 and the bottom side face 313. The top side face 311, the bottom side face 313, the left side face 312 and the right side face 314 are located at periphery of the second external surface 315, and a third transition face 311a is formed between the second external surface 315 and any one of them by means of 2.5D smooth transition of curvature, and the third transition face 311a has a width of 0.8mm to 1.6mm. It will be appreciated that the width of the third transition face 311a is a width of orthographic projection of the third transition face 311a onto the first reference plane. The third transition face 311a can increase the strength of the cover plate 300 such that the cover plate 300 has advantages of good hand feeling, being shatterproof and ease of click operation. In such a way, the display screen assembly of the electronic device 10 is more stereoscopic and with an excellent visual effect.

In an embodiment, the electronic device may be assembled according to the following order. The cover plate 300 and the display screen 200 are fastened to the middle frame 100 by a gum dispensing process. The camera module 400 is mounted into the middle frame 100. By means of the middle frame 100, the length and width directions of the camera module 400 are positioned. The lens 411 exposes by means of the through hole 112. The mother board 700 is mounted to the middle frame 100. A board-to-board (BTB) connector of the camera module 400 is engaged with the mother board 700. The pressing plate 800 is mounted to the middle frame 100 by screws. At a side of the mother board 700 opposite to the middle plate 150, the pressing plate 800 tightly presses the camera module 400 along a thickness direction of the electronic device 10. The battery cover 600 is fastened.

With promotion of a full screen display of the electronic device 10, the camera module 400 gradually approaches the top end of the middle frame 100. 2.5D curved faces at edges of the convex plate 320 of the cover plate 300 near the camera module 400 increase the size of the convex plate 320, and this affects the appearance. By eliminating the 2.5D curvature at edges of the top and lateral sides of the convex plate 320 such that the first external surface 324 and the top face 321, the left face 322, the right face 323 of the convex plate 320 are intersected vertically or transitioned by chamfered edges, the present application reduces the height L1 and the width L2 of the convex plate 320, thereby improving the appearance of the electronic device 10.

FIG. 15 is a structural schematic diagram illustrating an electronic device 10 provided in an embodiment of the present application. The electronic device 10 may include a radio frequency (RF) circuit 501, a storage 502 including one or more than one computer-readable storage medium, an input unit 503, a display unit 504, a sensor 505, an audio circuit 506, a Wireless Fidelity (WiFi) module 507, a processor 507 including one or more processing cores, a power supply 509, and etc. A person skilled in the art can understand that the structure of the electronic device 10 shown in FIG. 15 does not constitute a limitation to the electronic device 10, and may include more or less components than those illustrated in the drawings. Furthermore, some components of the electronic device 10 can be combined and/or arranged in different ways other than that shown in FIG. 15.

The RF circuit 501 can be used for transmitting and receiving information, or receiving and transmitting signals during a call. Specifically, after receiving downlink information of a base station, the RF circuit 501 transmits the downlink information to one or more processors 508 for processing. In addition, the RF circuit 501 transmits related uplink data to the base station. Generally, the RF circuit 501 includes, but is not limited to, an antenna, at least one amplifier, a tuner, one or more oscillators, a subscriber identity module (SIM) card, a transceiver, a coupler, and a low noise amplifier (LNA), a duplexer, etc. In addition, the RF circuit 501 can also communicate with the network and other devices through wireless communication. The wireless communication can use any communication standard or protocol, including but not limited to global system of mobile communication (GSM), general packet radio service (GPRS), and code division multiple access (CDMA), wideband code division multiple access (WCDMA), long term evolution (LTE), e-mail, short messaging service (SMS), and the like.

The storage 502 may be used to store application programs and data. The application programs stored in the storage 502 include executable codes. The application programs may construct various functional modules. By executing the application programs stored in the storage 502, the processor 508 may perform various functions and data processing. The storage 502 may include a code area and a data area, in which the code area is for storing an operating system, at least one application program needed for at least a function (such as an audio playback function and an image playback function), and the data area is for storing data (such as audio data and contacts) created according to a use of the electronic device 10. In addition, the storage 502 may include highspeed random access memory, and may further include non-volatile memory such as at least one magnetic disk storage device, flash memory, or other volatile solid-state storages. Correspondingly, the storage 502 may further include a storage controller for controlling access to the storage 502 from the processor 508 and the input unit 503.

The input unit 503 can be configured to receive input numbers, character information or user feature information (e.g., fingerprint), and generate signal input of a keyboard, a mouse, a joystick, or an optical trackball in relation to user settings and functional control. Specifically, in an implemented embodiment, the input unit 503 may include a touch sensitive surface and any other input device. The touch sensitive surface, which is also called a touch screen 200 or a touchpad, can gather a touch operation (for example, operations by use of a finger of a user, a stylus, and any other suitable object or attachment on or near the touch sensitive surface) applied on or near to the touch sensitive surface by the user and drive a connected device according to preset programs. Optionally, the touch sensitive surface may include a touch-sensitive device and a touch controller. The touch-sensitive device detects a direction of the user's touch, detects signals resulted from the touch operation, and transmits the signals to the touch controller. The touch controller receives information of the touch from the touch-sensitive device, converts it into a touch coordinate, further transmits the coordinate to the processor 508, and further receives and executes an instruction from the processor 508.

The display unit 504 may be configured to display information inputted by the user, information provided for the user, or various types of graphical user interfaces of the electronic device 10. The graphical user interfaces may include a graph, a text, an icon, a video, and any combination of them. The display unit 504 may include a display panel. Optionally, the display panel may be a liquid crystal display (LCD) or an organic light-emitting diode (OLED) display. Furthermore, the touch sensitive surface may cover the display panel. When the touch sensitive surface detects a touch operation on or near the touch sensitive surface and transmits a corresponding signal to the processor 508 to determine a type of the touch event, the processor 508 controls the display panel to provide appropriate visual output according to the type of the touch event. Although the touch sensitive surface and the display panel in FIG. 15 are two separate components for implementing input and output functions, the touch sensitive surface and the display panel may be integrated into one component for implementing the input and output functions in some embodiments. It will be appreciated that the surface) display screen 200 may include the input unit 503 and the display unit 504.

The electronic device 10 may further include at least one sensor 505, such as a light sensor, a motion sensor, and other sensors. Specifically, the light sensor can include an ambient light sensor and a proximity sensor. The ambient light sensor can adjust the brightness of the display panel according to bright or dark as to the ambient light. The proximity sensor can turn off the display panel and/or the backlight when the electronic device 10 is moved close to ears. As one type of the motion sensor, a gravity sensor (G-sensor) can detect acceleration on all directions (generally up to three axis), can detect magnitude and direction of the gravity when it stays still, and can identify a gesture in a cell phone application (such as a screen switch between landscape style and portrait style, relevant games, and magnetometer calibration) and recognize vibration patterns to identify relevant functions (such as pedometer, and knock), and so on. Additionally, a gyroscope, a barometer, a hygrometer, a thermometer, an infrared sensor, and any other sensor can be deployed in the electronic device 10, and the details for these are not repeated herein.

By a speaker and a microphone, the audio circuit 506 can provide an audio interface between the user and the mobile terminal 100. The audio circuit 506 converts received audio data to an electrical signal and transmits the electrical signal to the speaker. The speaker converts the electrical signal to sound signals and outputs the sound signals. In addition, the microphone converts collected sound signal to an electrical signal. The audio circuit converts the electrical signal to audio data and transmits the audio data to the processor 508 for further processing. After the processing, the audio data may be transmitted to another electronic device 10 via the RF circuit 501, or transmitted to the storage 502 for further processing. The audio circuit 506 may further include an earphone jack for providing communication between an external earphone and the electronic device 10.

WiFi is a short-distance wireless transmission technology. The electronic device 10 can help users send and receive e-mail, browse web pages and access streaming media through the WiFi module 507, which provides users with wireless broadband Internet access. Although FIG. 15 illustrates the WiFi module 507, it can be understood that it does not belong to the essential configuration of the electronic device 10, and may be omitted as needed within the scope of not changing the essence of the invention.

The processor 508 functions as a control center of the electronic device 10, sometimes also called a primary controller, and is configured to connect each component of the electronic device 10 using various interfaces and circuits, and is configured to execute or load application programs stored in the storage 502, to call the data stored in the storage 502 and to execute various functions of the electronic device 10 and perform data processing, thereby monitoring the overall electronic device 10. Optionally, the processor 508 may include one or more processing cores. Preferably, an application processor and a modulation/demodulation processor can be integrated to form the processor 508. The application processor is primarily configured to process an operating system, user interfaces, application programs, and so on. The modulation/demodulation processor is primarily configured to process wireless communication. It will be appreciated that the modulation/demodulation processor can be independent from the processor 508.

The electronic device 10 further includes the power supply 509 that supplies power to various components. Preferably, the power supply 509 can be logically coupled to the processor 508 through a power management system, to manage functions such as charging, discharging, and power management through the power management system. The power supply 509 may further include one or more direct current (DC)/or alternating current (AC) power sources, recharging system, power failure detection circuit, power converter or inverter, power supply status indicator, and the like.

Although not being shown in FIG. 15, the electronic device 10 may further include a BLUETOOTH module and so on, which is not repeated herein. During specific implementation, the foregoing modules may be implemented as independent entities, or may be implemented as one or more entities through random combination. For specific implementation of the foregoing modules, refer to the above method embodiments, and details are not described herein again.

Each technical characteristic of the embodiments may be freely combined, and for brief description, not all possible combinations of each technical characteristic in the embodiments are described.

The embodiments only express some implementation modes of the present application, and relatively specific and detailed descriptions are made thereto but should not thus be understood as limits to the scope of the invention. Therefore, the scope of protection of the present application shall be subject to the scope of protection of the appended claims.

## Claims

1. An electronic device (10), comprising:
a display screen (200), having a flat area;
a middle frame (100), comprising a border surrounding the display screen (200), wherein the border is provided with a groove (111), and the border is provided with a through hole (112) that penetrates a bottom of the groove (111);
a camera module (400), all or part of which is located inside the border, wherein the camera module (400) comprises a lens (411) for light entrance, and the lens (411) exposes by means of the through hole (112); and
a cover plate (300), comprising a convex plate (320) and a base plate (310) that are integrated into one piece, wherein the convex plate (320) is protruded from an edge at a side of the base plate (310), and when the base plate (310) and the convex plate (320) are orthographically projected onto a first reference plane, contours of orthographic projection of the base plate (310) and contours of orthographic projection of the convex plate (320) intersect at two points, the two points are connected to each other to form a reference straight line, the base plate (310) is located at a side of the reference straight line, and the convex plate (320) is located at the other side of the reference straight line; the base plate (310) covers the display screen (200), and the convex plate (320) is accommodated in the groove (111) and covers the lens (411); the convex plate (320) comprises a left face (322) and a right face (323) disposed opposite to each other, and a first external surface (324) disposed away from the lens (411) and connected between the left face (322) and the right face (323), the convex plate (320) comprises a top face (321) at a side opposite to the base plate (310), the top face (321) is connected between the left face (322) and the right face (323),
**characterized in that** a boundary of an angle of coverage of the camera module (400) intersects with the first external surface (324) to form intersections, wherein a minimal distance between the intersections and the top face (321) is 0.2mm to 1.4mm; or a minimal distance between the intersections and the left face (322) or the right face (323) is 0.2mm to 1.4mm.

2. The electronic device (10) according to claim 1, **characterized in that** at least one of the left face (322) and the right face (323) intersects with the first external surface (324) to form an included angle that is a right angle, or a second transition face (322a) is formed by means of sharp edge easing between the first external surface (324) and at least one of the left face (322) and the right face (323) and orthographic projection of the second transition face (322a) onto the first reference plane has a width of 0.1mm to 0.8mm; the first reference plane is a plane where the flat area of the display screen (200) is located.

3. The electronic device (10) according to claim 2, **characterized in that** the top face (321) intersects with the first external surface (324) to form an included angle that is a right angle; or a first transition face (321a) is formed by means of sharp edge easing between the first external surface (324) and the top face (321), and orthographic projection of the first transition face (321a) onto the first reference plane has a width of 0.1mm to 0.8mm.

4. The electronic device (10) according to claim 3, **characterized in that** the top face (321) is a plane.

5. The electronic device (10) according to any of claims 3 and 4, **characterized in that** a minimal distance between the intersections and the first transition face (321a) is 0.1mm to 0.6mm, and a minimal distance between the intersections and the second transition face (322a) is 0.1mm to 0.6mm.

6. The electronic device (10) according to any of claims 1 to 5, **characterized in that** a width of the convex plate (320) is 2.8mm to 4.4mm.

7. The electronic device (10) according to any of claims 1 to 6, **characterized in that** the base plate (310) comprises a top side face (311), the convex plate (320) is protruded from the top side face (311), and a size of the convex plate (320) protruded from the top side face (311) is 3.6mm to 4.8mm.

8. The electronic device (10) according to claim 7, **characterized in that** the base plate (310) comprises a left side face (312) and a right side face (314) disposed opposite to each other, a bottom side face (313) disposed opposite to the top side face (311), and a second external surface (315) disposed away from the display screen (200); the left side face (312) is connected to one end of the top side face (311) and the bottom side face (313), the right side face (314) is connected to the other end of the top side face (311) and the bottom side face (313), the top side face (311), the bottom side face (313), the left side face (312) and the right side face (314) are located at periphery of the second external surface (315), and the second external surface (315) and the first external surface (324) are coplanar; a third transition face (311a) is formed between the second external surface (315) and at least one of the top side face (311), the bottom side face (313), the left side face (312) and the right side face (314) by means of 2.5D smooth transition of curvature, and orthographic projection of the third transition face (311a) onto the first reference plane has a width of 0.8mm to 1.6mm.

9. The electronic device (10) according to any of claims 1 to 8, **characterized in that** the base plate (310) is shaped as a rectangle or a rectangle with round corners.

10. The electronic device (10) according to any of claims 1 to 8, **characterized in that** the middle frame (100) comprises the border and a middle plate (150), the border is located at periphery of the middle plate (150), an installation space is surrounded by the border and the middle plate (150), the cover plate (300) and the display screen (200) is located in the installation space, and the cover plate (300) is located at a side of the display screen (200) away from the middle plate (150); the border comprises a first lateral frame (120) and a second lateral frame (140) disposed opposite to each other and a bottom frame (130) and a top frame (110) disposed opposite to each other, the first lateral frame (120) is connected to one end of the top frame (110) and the bottom frame (130), and the second lateral frame (140) is connected to the other end of the top frame (110) and the bottom frame (130).

11. The electronic device (10) according to claim 10, **characterized in** comprising a mother board (700) located at a side of the middle plate (150) away from the cover plate (300), wherein the mother board (700) is provided with a notch (710), and the camera module (400) is disposed penetrating the notch (710); the electronic device (10) comprises a pressing plate (800) located at a side of the mother board (700) away from the middle plate (150), the pressing plate (800) is provided with a receiving slot (810), a part of the camera module (400) is received in the receiving slot (810), and the pressing plate (800) abuts on the camera module (400).

12. The electronic device (10) according to claim 2, **characterized in that** the first transition face (321a) is a plane or a cambered surface.

13. The electronic device (10) according to claim 3, **characterized in that** the top face (321) is a plane, and the second transition face (322a) is a plane or a cambered surface.

14. The electronic device (10) according to claim 1, **characterized in that** a width of the convex plate (320) is 2.8mm to 4.4mm.

## Patentansprüche

1. Elektronische Vorrichtung (10), umfassend:
einen Anzeigeschirm (200), der einen flachen Bereich aufweist;
einen Mittelrahmen (100), der einen den Anzeigeschirm (200) umgebenden Rand umfasst, wobei der Rand mit einer Nut (111) versehen ist und der Rand mit einem Durchgangsloch (112) versehen ist, das einen Boden der Nut (111) durchdringt;
ein Kameramodul (400), das sich ganz oder teilweise innerhalb des Randes befindet, wobei das Kameramodul (400) eine Linse (411) für den Lichteintritt umfasst und die Linse (411) mittels des Durchgangslochs (112) belichtet; und
eine Abdeckplatte (300), die eine konvexe Platte (320) und eine Basisplatte (310) umfasst, die in einem Stück integriert sind, wobei die konvexe Platte (320) von einer Kante an einer Seite der Basisplatte (310) hervorsteht, und wenn die Basisplatte (310) und die konvexe Platte (320) orthogonal auf eine erste Bezugsebene projiziert werden, die Konturen der Orthogonalprojektion der Basisplatte (310) und die Konturen der Orthogonalprojektion der konvexen Platte (320) sich in zwei Punkten schneiden, wobei die zwei Punkte miteinander verbunden sind, um eine Bezugsgerade zu bilden, die Basisplatte (310) sich an einer Seite der Bezugsgeraden befindet und die konvexe Platte (320) sich an der anderen Seite der Bezugsgeraden befindet; die Basisplatte (310) den Anzeigeschirm (200) abdeckt und die konvexe Platte (320) in der Nut (111) untergebracht ist und die Linse (411) abdeckt; die konvexe Platte (320) eine linke Fläche (322) und eine rechte Fläche (323), die einander gegenüberliegend angeordnet sind, und eine erste Außenfläche (324) aufweist, die von der Linse (411) weg angeordnet und zwischen der linken Fläche (322) und der rechten Fläche (323) verbunden ist, die konvexe Platte (320) eine obere Fläche (321) an einer der Basisplatte (310) gegenüberliegenden Seite aufweist, die obere Fläche (321) zwischen der linken Fläche (322) und der rechten Fläche (323) verbunden ist,
**dadurch gekennzeichnet, dass** eine Grenze eines Erfassungswinkels des Kameramoduls (400) sich mit der ersten Außenfläche (324) schneidet, um Schnittpunkte zu bilden, wobei ein minimaler Abstand zwischen den Schnittpunkten und der oberen Fläche (321) 0,2 mm bis 1,4 mm beträgt oder ein minimaler Abstand zwischen den Schnittpunkten und der linken Fläche (322) oder der rechten Fläche (323) 0,2 mm bis 1,4 mm beträgt.

2. Elektronische Vorrichtung (10) gemäß Anspruch 1, **dadurch gekennzeichnet, dass** mindestens eine der linken Fläche (322) und der rechten Fläche (323) sich mit der ersten Außenfläche (324) schneidet, um einen eingeschlossenen Winkel zu bilden, der ein rechter Winkel ist, oder eine zweite Übergangsfläche (322a) mittels einer scharfen Kantenabschrägung zwischen der ersten Außenfläche (324) und mindestens einer der linken Fläche (322) und der rechten Fläche (323) gebildet wird und die Orthogonalprojektion der zweiten Übergangsfläche (322a) auf die erste Bezugsebene eine Breite von 0,1 mm bis 0,8 mm; wobei die erste Bezugsebene eine Ebene ist, in der sich der flache Bereich des Anzeigeschirms (200) befindet.

3. Elektronische Vorrichtung (10) gemäß Anspruch 2, **dadurch gekennzeichnet, dass** sich die obere Fläche (321) mit der ersten Außenfläche (324) schneidet, um einen eingeschlossenen Winkel zu bilden, der ein rechter Winkel ist; oder dass eine erste Übergangsfläche (321a) mittels einer scharfen Kantenabschrägung zwischen der ersten Außenfläche (324) und der oberen Fläche (321) gebildet wird, und dass die Orthogonalprojektion der ersten Übergangsfläche (321a) auf die erste Bezugsebene eine Breite von 0,1 mm bis 0,8 mm aufweist.

4. Elektronische Vorrichtung (10) gemäß Anspruch 3, **dadurch gekennzeichnet, dass** die obere Fläche (321) eine Ebene ist.

5. Elektronische Vorrichtung (10) gemäß einem der Ansprüche 3 und 4, **dadurch gekennzeichnet, dass** ein minimaler Abstand zwischen den Schnittpunkten und der ersten Übergangsfläche (321a) 0,1 mm bis 0,6 mm beträgt und ein minimaler Abstand zwischen den Schnittpunkten und der zweiten Übergangsfläche (322a) 0,1 mm bis 0,6 mm beträgt.

6. Elektronische Vorrichtung (10) gemäß einem der Ansprüche 1 bis 5, **dadurch gekennzeichnet, dass** eine Breite der konvexen Platte (320) 2,8 mm bis 4,4 mm beträgt.

7. Elektronische Vorrichtung (10) gemäß einem der Ansprüche 1 bis 6, **dadurch gekennzeichnet, dass** die Basisplatte (310) eine Oberseitenfläche (311) aufweist, die konvexe Platte (320) von der Oberseitenfläche (311) vorsteht und eine Größe der von der Oberseitenfläche (311) vorstehenden konvexen Platte (320) 3,6 mm bis 4,8 mm beträgt.

8. Elektronische Vorrichtung (10) gemäß Anspruch 7, **dadurch gekennzeichnet, dass** die Basisplatte (310) eine linke Seitenfläche (312) und eine rechte Seitenfläche (314), die einander gegenüberliegend angeordnet sind, eine untere Seitenfläche (313), die der oberen Seitenfläche (311) gegenüberliegend angeordnet ist, und eine zweite Außenfläche (315), die vom Anzeigeschirm (200) entfernt angeordnet ist, umfasst; die linke Seitenfläche (312) mit einem Ende der oberen Seitenfläche (311) und der unteren Seitenfläche (313) verbunden ist, die rechte Seitenfläche (314) mit dem anderen Ende der oberen Seitenfläche (311) und der unteren Seitenfläche (313) verbunden ist, die obere Seitenfläche (311), die untere Seitenfläche (313), die linke Seitenfläche (312) und die rechte Seitenfläche (314) sich am Umfang der zweiten Außenfläche (315) befinden, und die zweite Außenfläche (315) und die erste Außenfläche (324) koplanar sind; eine dritte Übergangsfläche (311a) zwischen der zweiten Außenfläche (315) und mindestens einer der oberen Seitenfläche (311), der unteren Seitenfläche (313), der linken Seitenfläche (312) und der rechten Seitenfläche (314) mittels eines 2,5D glatten Übergangs der Krümmung gebildet wird, und die Orthogonalprojektion der dritten Übergangsfläche (311a) auf die erste Bezugsebene eine Breite von 0,8 mm bis 1,6 mm aufweist.

9. Elektronische Vorrichtung (10) gemäß einem der Ansprüche 1 bis 8, **dadurch gekennzeichnet, dass** die Basisplatte (310) als Rechteck oder als Rechteck mit runden Ecken ausgebildet ist.

10. Elektronische Vorrichtung (10) gemäß einem der Ansprüche 1 bis 8, **dadurch gekennzeichnet, dass** der Mittelrahmen (100) den Rand und eine Mittelplatte (150) umfasst, der Rand sich am Umfang der Mittelplatte (150) befindet, ein Einbauraum von dem Rand und der Mittelplatte (150) umgeben ist, die Abdeckplatte (300) und der Anzeigeschirm (200) sich in dem Einbauraum befinden, und die Abdeckplatte (300) sich an einer von der Mittelplatte (150) entfernten Seite des Anzeigeschirms (200) befindet; der Rand einen ersten seitlichen Rahmen (120) und einen zweiten seitlichen Rahmen (140), die einander gegenüberliegend angeordnet sind, und einen unteren Rahmen (130) und einen oberen Rahmen (110), die einander gegenüberliegend angeordnet sind, umfasst, wobei der erste seitliche Rahmen (120) mit einem Ende des oberen Rahmens (110) und des unteren Rahmens (130) verbunden ist und der zweite seitliche Rahmen (140) mit dem anderen Ende des oberen Rahmens (110) und des unteren Rahmens (130) verbunden ist.

11. Elektronische Vorrichtung (10) gemäß Anspruch 10, **dadurch gekennzeichnet, dass** sie eine Hauptplatine (700) umfasst, die sich an einer von der Abdeckplatte (300) entfernten Seite der Mittelplatte (150) befindet, wobei die Hauptplatine (700) mit einer Kerbe (710) versehen ist und das Kameramodul (400) die Kerbe (710) durchdringend angeordnet ist; die elektronische Vorrichtung (10) eine Pressplatte (800) umfasst, die sich an einer von der Mittelplatte (150) entfernten Seite der Hauptplatine (700) befindet, wobei die Pressplatte (800) mit einem Aufnahmeschlitz (810) versehen ist, ein Teil des Kameramoduls (400) in dem Aufnahmeschlitz (810) aufgenommen wird und die Pressplatte (800) an dem Kameramodul (400) anliegt.

12. Elektronische Vorrichtung (10) gemäß Anspruch 2, **dadurch gekennzeichnet, dass** die erste Übergangsfläche (321a) eine Ebene oder eine gewölbte Fläche ist.

13. Elektronische Vorrichtung (10) gemäß Anspruch 3, **dadurch gekennzeichnet, dass** die obere Fläche (321) eine Ebene ist und die zweite Übergangsfläche (322a) eine Ebene oder eine gewölbte Fläche ist.

14. Elektronische Vorrichtung (10) gemäß Anspruch 1, **dadurch gekennzeichnet, dass** eine Breite der konvexen Platte (320) 2,8 mm bis 4,4 mm beträgt.

## Revendications

1. Dispositif électronique (10), comprenant :
un écran d'affichage (200), ayant une zone plate ;
un cadre médian (100), comprenant une bordure entourant l'écran d'affichage (200), dans lequel la bordure est pourvue d'une rainure (111), et la bordure est pourvue d'un trou débouchant (112) qui pénètre dans un fond de la rainure (111) ;
un module de caméra (400), dont la totalité ou une partie est située à l'intérieur de la bordure, dans lequel le module de caméra (400) comprend une lentille (411) pour l'entrée de lumière, et la lentille (411) s'expose au moyen du trou débouchant (112) ; et
une plaque couvercle (300), comprenant une plaque convexe (320) et une plaque de base (310) qui sont intégrées en une pièce, dans lequel la plaque convexe (320) est en saillie à partir d'un bord sur un côté de la plaque de base (310), et, lorsque la plaque de base (310) et la plaque convexe (320) sont projetées orthographiquement sur un premier plan de référence, des contours de projection orthographique de la plaque de base (310) et des contours de projection orthographique de la plaque convexe (320) s'intersectent à deux points, les deux points sont reliés l'un à l'autre pour former une ligne droite de référence, la plaque de base (310) est située sur un côté de la ligne droite de référence, et la plaque convexe (320) est située sur l'autre côté de la ligne droite de référence ; la plaque de base (310) couvre l'écran d'affichage (200), et la plaque convexe (320) est logée dans la rainure (111) et couvre la lentille (411) ; la plaque convexe (320) comprend une face de gauche (322) et une face de droite (323) disposées de façon opposée l'une à l'autre, et une première surface externe (324) disposée de façon éloignée de la lentille (411) et reliée entre la face de gauche (322) et la face de droite (323), la plaque convexe (320) comprend une face supérieure (321) sur un côté opposé à la plaque de base (310), la face supérieure (321) est reliée entre la face de gauche (322) et la face de droite (323),
**caractérisé en ce qu'**une limite d'un angle de couverture du module de caméra (400) intersecte la première surface externe (324) pour former des intersections, dans lequel une distance minimale entre les intersections et la face supérieure (321) est de 0,2 mm à 1,4 mm ; ou une distance minimale entre les intersections et la face de gauche (322) ou la face de droite (323) est de 0,2 mm à 1,4 mm.

2. Dispositif électronique (10) selon la revendication 1, **caractérisé en ce qu'**au moins une de la face de gauche (322) et de la face de droite (323) intersecte la première surface externe (324) pour former un angle inclus qui est un angle droit, ou une deuxième face de transition (322a) est formée au moyen d'un bord vif s'introduisant entre la première surface externe (324) et au moins une de la face de gauche (322) et de la face de droite (323) et une projection orthographique de la deuxième face de transition (322a) sur le premier plan de référence a une largeur de 0,1 mm à 0,8 mm ; le premier plan de référence est un plan où la zone plate de l'écran d'affichage (200) est située.

3. Dispositif électronique (10) selon la revendication 2, **caractérisé en ce que** la face supérieure (321) intersecte la première surface externe (324) pour former un angle inclus qui est un angle droit ; ou une première face de transition (321a) est formée au moyen d'un bord vif s'introduisant entre la première surface externe (324) et la face supérieure (321), et une projection orthographique de la première face de transition (321a) sur le premier plan de référence a une largeur de 0,1 mm à 0,8 mm.

4. Dispositif électronique (10) selon la revendication 3, **caractérisé en ce que** la face supérieure (321) est un plan.

5. Dispositif électronique (10) selon l'une quelconque des revendications 3 et 4, **caractérisé en ce qu'**une distance minimale entre les intersections et la première face de transition (321a) est de 0,1 mm à 0,6 mm, et une distance minimale entre les intersections et la deuxième face de transition (322a) est de 0,1 mm à 0,6 mm.

6. Dispositif électronique (10) selon l'une quelconque des revendications 1 à 5, **caractérisé en ce qu'**une largeur de la plaque convexe (320) est de 2,8 mm à 4,4 mm.

7. Dispositif électronique (10) selon l'une quelconque des revendications 1 à 6, **caractérisé en ce que** la plaque de base (310) comprend une face de côté supérieur (311), la plaque convexe (320) est en saillie à partir de la face de côté supérieur (311), et une taille de la plaque convexe (320) en saillie à partir de la face de côté supérieur (311) est de 3,6 mm à 4,8 mm.

8. Dispositif électronique (10) selon la revendication 7, **caractérisé en ce que** la plaque de base (310) comprend une face de côté gauche (312) et une face de côté droit (314) disposées de façon opposée l'une à l'autre, une face de côté inférieur (313) disposée de façon opposée à la face de côté supérieur (311), et une seconde surface externe (315) disposée de façon éloignée de l'écran d'affichage (200) ; la face de côté gauche (312) est reliée à une extrémité de la face de côté supérieur (311) et de la face de côté inférieur (313), la face de côté droit (314) est reliée à l'autre extrémité de la face de côté supérieur (311) et de la face de côté inférieur (313), la face de côté supérieur (311), la face de côté inférieur (313), la face de côté gauche (312) et la face de côté droit (314) sont situées à la périphérie de la seconde surface externe (315), et la seconde surface externe (315) et la première surface externe (324) sont coplanaires ; une troisième face de transition (311a) est formée entre la seconde surface externe (315) et au moins une de la face de côté supérieur (311), de la face de côté inférieur (313), de la face de côté gauche (312) et de la face de côté droit (314) au moyen de transition lisse 2,5D de courbure, et une projection orthographique de la troisième face de transition (311a) sur le premier plan de référence a une largeur de 0,8 mm à 1,6 mm.

9. Dispositif électronique (10) selon l'une quelconque des revendications 1 à 8, **caractérisé en ce que** la plaque de base (310) est sous la forme d'un rectangle ou d'un rectangle avec des coins arrondis.

10. Dispositif électronique (10) selon l'une quelconque des revendications 1 à 8, **caractérisé en ce que** le cadre médian (100) comprend la bordure et une plaque médiane (150), la bordure est située à la périphérie de la plaque médiane (150), un espace d'installation est entouré par la bordure et la plaque médiane (150), la plaque couvercle (300) et l'écran d'affichage (200) sont situés dans l'espace d'installation, et la plaque couvercle (300) est située sur un côté de l'écran d'affichage (200) éloigné de la plaque médiane (150) ; la bordure comprend un premier cadre latéral (120) et un second cadre latéral (140) disposés de façon opposée l'un à l'autre et un cadre inférieur (130) et un cadre supérieur (110) disposés de façon opposée l'un à l'autre, le premier cadre latéral (120) est relié à une extrémité du cadre supérieur (110) et du cadre inférieur (130), et le second cadre latéral (140) est relié à l'autre extrémité du cadre supérieur (110) et du cadre inférieur (130).

11. Dispositif électronique (10) selon la revendication 10, **caractérisé en ce qu'**il comprend une carte mère (700) située sur un côté de la plaque médiane (150) éloigné de la plaque couvercle (300), dans lequel la carte mère (700) est pourvue d'une entaille (710), et le module de caméra (400) est disposé de façon pénétrant l'entaille (710) ; le dispositif électronique (10) comprend une plaque de pression (800) située sur un côté de la carte mère (700) éloigné de la plaque médiane (150), la plaque de pression (800) est pourvue d'une fente de réception (810), une partie du module de caméra (400) est reçue dans la fente de réception (810), et la plaque de pression (800) prend appui sur le module de caméra (400).

12. Dispositif électronique (10) selon la revendication 2, **caractérisé en ce que** la première face de transition (321a) est un plan ou une surface cambrée.

13. Dispositif électronique (10) selon la revendication 3, **caractérisé en ce que** la face supérieure (321) est un plan, et la deuxième face de transition (322a) est un plan ou une surface cambrée.

14. Dispositif électronique (10) selon la revendication 1, **caractérisé en ce qu'**une largeur de la plaque convexe (320) est de 2,8 mm à 4,4 mm.
